Europäisches Patentamt

European Patent Office

Office européen des brevets

(19)

(11) Veröffentlichungsnummer: **0 054 647**
A2

## (12) EUROPÄISCHE PATENTANMELDUNG

(21) Anmeldenummer: 81108241.1

(22) Anmeldetag: 12.10.81

(51) Int. Cl.³: **H 01 L 47/02**

(30) Priorität: 18.12.80 DE 3047843

(43) Veröffentlichungstag der Anmeldung: 30.06.82
Patentblatt 82/26

(84) Benannte Vertragsstaaten: **DE FR GB IT**

(71) Anmelder: **SIEMENS AKTIENGESELLSCHAFT Berlin und München, Postfach 22 02 61, D-8000 München 22 (DE)**

(72) Erfinder: **Müller, Jörg, Dr., Herzog-Tassilo-Ring 44, D-8011 Zorneding (DE)**

(54) **Gunn-Element und Verfahren zu dessen Herstellung.**

(57) Die Erfindung betrifft ein Gunn-Element (1), bei dem auf einem Galliumarsenid- bzw. Indiumphosphid-Substrat (2) epitaktisch eine Schicht (3), bestehend aus dem gleichen Halbleitermaterial wie das Substrat (3) abgeschieden ist und bei dem in diese epitaktisch abgeschiedene Schicht (3) Isolatorbereiche (4) durch Wasserstoffimplantation eingebracht sind.

Die Erfindung ist anwendbar auf Gunn-Elemente für Bewegungsmelder oder Hochfrequenzoszillatorschaltungen.

EP 0 054 647 A2

SIEMENS AKTIENGESELLSCHAFT

Berlin und München

0054647

Unser Zeichen

VPA 80 P 1 2 0 0 E

## Gunn-Element und Verfahren zu dessen Herstellung.

Die Erfindung betrifft ein Gunn-Element, bestehend aus Halbleitermaterial mit Isolatorschichten.

Es wurde bereits versucht, zur Herstellung von Gunn-Elementen, die mit geringen Strömen betrieben werden sollen, Mesa-Ätzungen anzuwenden. Derartige Strukturen weisen jedoch eine hohe Zerbrechlichkeit auf, da ihre mechanische Stabilität insbesondere beim Zusammenbau mit gewissen Trägerplatten oder Wärmesenken sehr gering ist. Weiterhin ist die Wärmeableitung und die Stromverteilung insbesondere in den Randbereichen zur Mesa-Ätzung hin ungünstig, so daß die Qualität und der Anwendungsbereich hiernach gefertigter Gunn-Elemente beeinträchtigt ist. Außerdem werden durch das Mesa-Ätzen Halbleiteroberflächen freigelegt, die gegen die Einwirkung von Umwelteinflüssen wiederum mittels eines hermetischen Gehäuses geschützt werden müssen, was einen erheblichen Arbeitsaufwand, einerseits bezüglich Mesa-Ätzung und andererseits bezüglich Gehäuseeinbau, erfordert.

Aufgabe der vorliegenden Erfindung ist es daher, ein Gunn-Element anzugeben, das sowohl einfach herstellbar und mechanisch stabil ist als auch bei relativ großen Kontaktflecken mit geringen Strömen bei einer günstigen Stromverteilung und Wärmeableitung betrieben werden kann und auch bei kleinen Leistungen einen hohen Wirkungsgrad aufweist.

Diese Aufgabe zur Erzeugung eines Gunn-Elementes wird dadurch gelöst, daß auf ein Galliumarsenid- bzw. Indiumphosphid-Substrat epitaktisch eine Schicht, bestehend

Kus 1 Lk /2.12.1980

aus dem gleichen Halbleitermaterial wie das Substrat, abgeschieden ist, und daß in diese epitaktisch abgeschiedene Schicht Isolatorbereiche durch Ionenimplantation, insbesondere durch Wasserstoffimplantation eingebracht sind.

Durch die Ionenimplantation, insbesondere die Wasserstoffimplantation wird die Herstellung von erfindungsgemäßen Gunn-Elementen gegenüber der üblichen Herstellung mittels Mesa-Ätzen wesentlich vereinfacht. Es wird sowohl das Mesa-Ätzen sowie gegebenenfalls das Einbauen in ein Gehäuse eingespart. Gleichzeitig ist die mechanische Stabilität erfindungsgemäß hergestellter Gunn-Elemente hinsichtlich Bruchfestigkeit größer als bei solchen Bauelementen, die mittels Mesa-Ätzung hergestellt sind. Auch das Unterteilen in Einzelbauelemente ist durch die Maßnahme der Wasserstoffimplantation wesentlich vereinfacht gegenüber entsprechender mesageätzter Bauelemente. Die Trennung der Einzelbauelemente kann durch einfaches Ritzen und Brechen erfolgen. Da die Wasserstoffimplantation auch gleichzeitig eine Ringsumpassivierung des Bauelementes darstellt, läßt sich dadurch auch das Einkapseln der Bauelemente in hermetisch dichte Gehäuse einsparen, was wiederum eine erhebliche Vereinfachung und Verbilligung des Herstellungsverfarens birgt.

Durch die Wasserstoffimplantation lassen sich außerdem sehr kleine Leistungen bei hohem Wirkungsgrad des Bauelements erzielen. Da wasserstoffimplantiertes Galliumarsenid bzw. Indiumphosphid eine wesentlich höhere Dielektrizitätskonstante als Luft aufweisen, wird eine größere Parallelkapazität erzeugt, wodurch unerwünschte Oberwellen gedämpft werden. Die bei mesageätzten Gunn-Elementen auftretende seitliche Auffächerung der elektrischen Feldlinien wird wesentlich verringert. Gleichzeitig mit dem Vorteil eines hohen Wirkungsgrades bei erwünschter kleiner Leistung wird auch das Frequenzrauschen geringer, da

0054647

mit einer Minimierung der Auffächerung der seitlichen Stromverteilung zugleich eine Minimierung der Abweichung der Elektronenwolkenlaufwege verbunden ist, und somit das Frequenzrauschen minimiert ist. Schließlich ergibt sich auch ein kleinerer Wärmewiderstand für hohe Leistungen, da Stromwärme über wasserstoffimplantierte Isolatorbereiche abgeführt wird.

Durch die Vermeidung der Auffächerung elektrischer Feldlinien an den Randgebieten eines erfindungsgemäßen Gunn-Elementes wird die Stromverteilung im Bauelement gleichmäßiger, so daß auch Wärmestaus innerhalb des Halbleiterbauelementes vermieden werden. Damit wird das Bauelement auch weniger anfällig gegen eine falsche elektrische Polung.

Es ist vorteilhaft, daß die Wasserstoffimplantation selbstjustierend erfolgt. Dadurch läßt sich sowohl der Platzbedarf am Chip minimieren - eine Tatsache, die bei fortschreitender Technik immer größere Bedeutung gewinnt - als auch eine genaue Definition der stromführenden Fläche erreichen.

Schließlich läßt sich durch die Tatsache einer selbstjustierenden Implantation und bei hoher Gleichmäßigkeit der Implantation eine hohe Reproduzierbarkeit der elektrischen Parameter der einzelnen hiernach gefertigten Gunn-Elemente bewirken.

Es ist vorteilhaft, daß die eingebrachten Isolatorbereiche eine Dicke aufweisen, die der Dicke der epitaktischen Schicht entspricht oder geringer ist als die Dicke der epitaktischen Schicht. Weisen die eingebrachten Isolatorbereiche eine Dicke auf, die der Dicke der epitaktischen Schicht entspricht, so läßt sich die Streuung der elektrischen Parameter minimieren.

Es ist auch vorteilhaft, daß die Dicke der abgeschiedenen Isolatorbereiche ein Drittel bis zwei Drittel der Dicke der epitaktischen Schicht beträgt.

Letztere Maßnahme bewirkt eine geringe Belastung der kritischen Anode und einen geringen Wärmewiderstand, woraus sich höhere Verlustleistungen ergeben.

Es ist auch erfinderisch, daß an der größten äußeren Oberfläche des Substrats ein erster Kontakt ganzflächig vorgesehen ist, während an leitenden Bereichen der epitaktisch abgeschiedenen Schicht ein zweiter Kontakt vorgesehen ist, und daß der zweite Kontakt auch Teile der Isolatorschicht überlagert. Durch die letztgenannte Maßnahme ist die Kapazität, aus der zweiten Kontaktschicht oberhalb der Isolatorschicht und der Substratschicht unterhalb der Isolatorschicht eine Kapazität, die parallel zur Stromrichtung im Gunn-Element liegt und somit einen Kurzschluß für hochfrequente Schwingungen darstellt. Durch diese Maßnahme können Oberwellen der erzeugten elektrischen Schwingung unterdrückt werden, was häufig vorteilhaft und wünschenswert ist. Außerdem läßt sich durch diese Maßnahme eine verbesserte Haftung des Kontaktierungsfleckes sowie die Verwirklichung geringer Ströme bei großen Kontaktierflecken erreichen.

Es ist auch vorteilhaft, daß eine Wärmesenke so angebracht ist, daß wahlweise entweder die erste oder die zweite Kontaktschicht mit der Wärmesenke fest verbunden ist. Durch diese Maßnahme läßt sich je nach Bedarf die Wärme über den Kontakt am Substrat oder den Kontakt an der epitaktischen Schicht ableiten, was je nach Anwendung des Gunn-Elementes sehr wichtig und sehr vorteilhaft ist. Im Falle von mesageätzten Strukturen ist ein Anbringen von Wärmesenken an dem Kontakt der epitaktisch abgeschiedenen Schicht im allgemeinen problematisch, weil dadurch die Zerbrechlichkeit der mesageätzten Gunn-Elemente her-

- 5 - VPA 80 P 1200 E 0054647

aufgesetzt wird.

Zur Herstellung eines erfindungsgemäßen Gunn-Elementes ist es vorteilhaft, daß ein Substrat, bestehend aus Galliumarsenid oder Indiumphosphid, das z.B. eine n+-Dotierung aufweist, einseitig mit einer z.B. n-dotierten epitaktisch abgeschiedenen Schicht versehen wird, die wiederum mit einer weiteren n+-dotierten epitaktisch abgeschiedenen Schicht bedeckt sein kann, daß auf der bzw. den epitaktisch abgeschiedenen Schichten eine Passivierungsschicht, z.B. bestehend aus $SiO_2$ und/oder $Si_3N_4$, abgeschieden wird, daß mittels fotolithografischer Verfahren die Passivierungsschicht an den Stellen, an denen Kontakte vorgesehen sind, entfernt und abgeschieden wird, daß die verbliebenen Isolatorbereiche dieser Oberfläche frei von Kontaktmaterial bleiben, daß selbstjustierend zu diesen Kontakten eine Wasserstoffimplantation erfolgt, daß danach eine ganzflächige Kontaktabscheidung auf der Oberfläche der epitaktisch abgeschiedenen Schicht erfolgt, daß anschließend mittels fotolithografischer Verfahren das gewünschte Kontaktmuster an der epitaktisch abgeschiedenen Oberfläche erzeugt wird, daß daran anschließend oder vor der selbstjustierenden Wasserstoffimplantation eine ganzflächige Metallisierung der äußeren Substratoberfläche erfolgt, daß anschließend eine integrierte Wärmesenke wahlweise an den Kontaktflecken der epitaktisch abgeschiedenen Schicht oder an der ganzflächigen Substratmetallisierung angebracht wird.

Die ganzflächige Kontaktabscheidung der äußeren Substratoberfläche wird im allgemeinen vor der selbstjustierenden Wasserstoffimplantation durchgeführt. Da mit dieser Implantation Kristallfehler erzeugt werden, die die Leitfähigkeit dieser Bereiche in gewünschter Weise herabsetzen, würde ein nachfolgender Temperaturschritt, wie er beispielsweise durch die ganzflächige Metallbedampfung der äußeren Substratoberfläche gegeben ist, die absichtlich erzeugten Kristallfehler wiederum ausheilen, was eine Heraufsetzung der Leitfähigkeit der Isolatorbereiche in unerwünschter Weise zur Folge hätte.

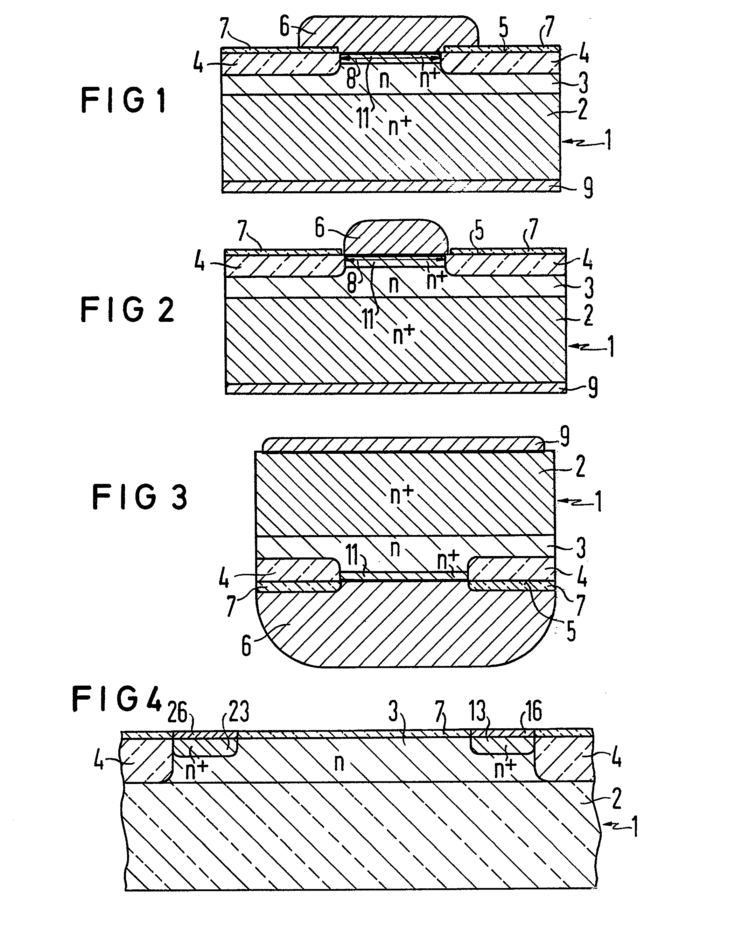

Nachfolgend wird die Erfindung an einem Ausführungsbeispiel und der Zeichnung näher erläutert. Es zeigen: Die Figuren 1 bis 4 stellen vier unterschiedliche Ausführungsbeispiele eines erfindungsgemäßen Gunn-Elementes dar.

Figur 1 zeigt ein Gunn-Element 1, bei dem ein Substrat 2 z.B. bestehend aus n+-dotiertem Galliumarsenid (GaAs) oder Indiumphosphid (InP) mit einer epitaktisch abgeschiedenen Schicht 3, die z.B. aus dem gleichen n-dotierten Material besteht, versehen ist. Die n-dotierte epitaktisch abgeschiedene Schicht 3 kann von einer weiteren ganzflächig abgeschiedenen n+-dotierten Schicht 11 überlagert sein, wodurch z.B. gute Kontaktgabe an den Kontakten erreicht wird. Diese Maßnahme ist jedoch nicht zwingend notwendig. In die epitaktisch abgeschiedene Schicht 3 und gegebenenfalls Schicht 11 sind Isolatorbereiche 4 mittels Ionenimplantation, z.B. mittels Wasserstoffimplantation eingebracht. Die Oberfläche 5 der epitaktisch abgeschiedenen Schicht 3 ist bis auf diejenigen Stellen, an denen ein Stromfluß zwischen Kontaktflecken 6 auf der Oberfläche der epitaktisch abgeschiedenen Schicht 3 und der darunter liegenden Halbleiterschicht erfolgen soll, mit einer Passivierungsschicht 7 versehen. Die Passivierungsschicht 7 kann aus Siliciumdioxid ($SiO_2$) und/oder Siliciumnitrid ($Si_3N_4$) bestehen. Der Kontaktfleck 6 kontaktiert einerseits die leitenden Bereiche 8 der epitaktisch abgeschiedenen Schicht 3 bzw. der Schicht 11 und überlagert außerdem einen Teil der Isolatorbereiche 4. An der Rückseite des Substrats 2 ist ein ganzflächiger Kontakt 9 angebracht. Dieser Kontakt 9 bildet gleichzeitig eine integrierte Wärmesenke.

In den nachfolgenden Figuren sind gleiche Gegenstände mit gleichen Bezugzeichen versehen, weshalb diese nicht eigens nochmals erläutert werden.

Figur 2 zeigt ein erfindungsgemäßes Gunn-Element, das gegenüber Figur 1 Kontaktflecken 6 aufweist, die die Isolatorbereiche 4 nicht überlagern.

Figur 3 zeigt ein erfindungsgemäßes Gunn-Element, das gegenüber Figur 1 eine integrierte Wärmesenke an den Kontaktflecken 6 aufweist und mittels dieser Kontaktflecken auch auf eine feste Halterung aufgebracht ist.

Figur 4 zeigt im Gegensatz zu Figur 1 eine planare Anordnung eines Gunn-Elements, bei dem das Substrat 2 im Gegensatz zu Figur 1 semi-isolierend ist. Die epitaktisch abgeschiedene Schicht 3 auf dem Substrat ist z.B. n-leitend. Die Isolatorbereiche 4 sind wie in Figur 1 mittels Wasserstoffimplantation eingebracht. Unterhalb des Kathodenkontakts 16 ist ein n+-dotierter Bereich 13 und unterhalb des Anodenkontaktes 26 ein n+-dotierter Bereich 23 in die epitaktisch abgeschiedene n-dotierte Schicht 3 eingebracht.

Zur Herstellung eines erfindungsgemäßen Gunn-Elements nach den Figuren 1 bis 3 wird ein aus Galliumarsenid (GaAs) oder Indiumphosphid (InP) bestehendes Substrat verwendet, das z.B. n+-dotiert ist, mit einer epitaktischen Schicht des gleichen Halbleitermaterials, die z.B. n-dotiert ist, versehen ist. Auf die epitaktisch abgeschiedene Schicht 3 wird gegebenenfalls eine n+-dotierte Schicht 11 des gleichen Halbleitermaterials abgeschieden. Eine Passivierungsschicht, z.B. bestehend aus $SiO_2$ und/oder $Si_3O_4$ wird ganzflächig darüber abgeschieden, d.h. auf der Oberfläche der Schicht 3 oder gegebenenfalls auf der Oberfläche der Schicht 11 abgeschieden. Mittels eines fotolithografischen Verfahrens wird die Passivierungsschicht an den Stellen, an denen Kontakte vorgesehen sind, entfernt und auf den freigelegten Halbleiteroberflächenteilen werden Kontaktierungen, z.B. bestehend aus den Metallen Indium (In), Silber (Ag) und Germanium (Ge) oder aus Germanium (Ge) und Gold (Au) aufgebracht. Eine einfache Herstellung dieser Kontaktabscheidung läßt sich mittels der sogenannten Abhebetechnik erreichen. Dazu wird bei dem vorangehenden fotolithografischen Verfahren zur Ätzung der Passivierungsschicht ein Fotolack verwendet, der eine starke Quellfähigkeit besitzt. Nach der Strukturätzung der Passivierungsschicht wird ganzflächig eine Metallisierung, z.B. bestehend aus den oben genannten Metallen abgeschieden. Danach läßt man die Fotolackreste quellen, so daß die Metallisierung an den Rändern der Fotolackschicht abreißt und mit dieser abgehoben werden kann. Metallflecke bleiben lediglich auf den durch die Ätzung freigelegten Halbleiterteilen zurück. Anschließend erfolgt die Rückseitenkontaktierung am Halbleitersubstrat durch eine ganzflächige Metallisierung z.B. bestehend aus einem oder mehreren der Metalle Indium (In), Silber (Ag), Germanium (Ge), Gold (Au), Nickel (Ni). Danach erfolgt selbstjustierend zu den Metallflecken an der epitaktisch aufgebrachten Schicht 3 bzw. gegebenenfalls und der Schicht 11 eine Wasserstoffimplantation durch die Passivierungsschicht hindurch, die die darunter liegende epitaktische Schicht 3 und gegebenenfalls die Schicht 11 entweder ganz oder bis zu einer Schichtstärke von einem Drittel der Gesamtschichtdicke bis zu zwei Dritteln der Gesamtschichtdicke durchsetzt. Anschließend werden die Kontaktflecke der epitaktisch abgeschiedenen Schicht 3 bzw. der Schicht 11 durch eine weitere zweite Metallisierung verstärkt, wobei diese Metallisierung wie in Figur 1 oder Figur 3 auch Teile der Isolatorschicht überlagern kann.

0054647

Bei Gunn-Elementen, die mit geringer Leistung betrieben werden, wird der Aufbau auf eine Bodenplatte und die Anbringung einer Wärmesenke so vorgenommen, wie in Figuren 1 und 2 beschrieben. Bei Gunn-Elementen mit hoher Leistung wird hingegen der Aufbau auf eine Bodenplatte und die Anbringung einer Wärmesenke so vorgenommen wie in Figur 3 beschrieben.

Zur Herstellung eines erfindungsgemäßen Gunn-Elementes nach Figur 4 wird ein semi-isolierendes Halbleitersubstrat, z.B. bestehend aus Galliumarsenid oder indiumphosphid verwendet, in welches Zusätze zur Herabsetzung der elektrischen Leitfähigkeit, z.B. Chrom, eingebracht sind. Auf dieses Substrat wird eine Schicht aus dem gleichen Halbleitermaterial epitaktisch abgeschieden. Auf der epitaktisch abgeschiedenen Oberfläche wird eine Passivierungsschicht, z.B. bestehend aus Siliciumdioxid und/oder Siliciumnitrid angebracht. Mittels fotolithografischer Verfahren werden in eine z.B. n-dotierte epitaktisch abgeschiedene Halbleiterschicht n+-dotierte Bereiche für den Kathoden- und den Anodenanschluß durch Epitaxie oder Implantation oder Diffusion eingebracht. Auf den Kathoden- und Anodenbereichen werden an der Oberfläche Kontaktschichten angebracht, wobei z.B. die verwendete Metallkontaktschicht zunächst auch den aktiven Bereich zwischen den Kathoden- und Anodenbereichen abdeckt. Danach werden diejenigen Bereiche der epitaktisch abgeschiedenen Schicht, die vom Kontaktmaterial nicht abgedeckt sind, mittels Wasserstoffimplantation in Isolatorbereiche verwandelt. Diese Isolatorbereiche durchsetzen dabei die gesamte Schichtdicke der epitaktisch abgeschiedenen Schicht.

Alle nach den Figuren 1 bis 4 dargestellten erfindungsgemäßen Gunn-Elemente können durch Unterteilen einer Halbleiterscheibe mittels Sägen oder Ritzen und Brechen einfach in Einzelelemente unterteilt werden.

0054647

Erfindungsgemäße Gunn-Elemente eignen sich z.B. zur Herstellung von Gunn-Elementen oder Oszillatoren, die z.B. in G$_e$räte wie Bewegungsmelder oder Hochfrequenzoszillatorschaltungen eingebaut werden können.

8 Patentansprüche
4 Figuren

0054647

Patentansprüche

1. Gunn-Element, bestehend aus Halbleitermaterial mit Isolatorschichten, d a d u r c h  g e k e n n z e i ch n e t,  daß auf ein Galliumarsenid- bzw. Indiumphosphid-Substrat epitaktisch eine Schicht, bestehend aus dem gleichen Halbleitermaterial wie das Substrat, abgeschieden ist und daß in diese epitaktisch abgeschiedene Schicht Isolatorbereiche durch Ionenimplantation, insbesondere durch Wasserstoffimplantation, eingebracht sind.

2. Gunn-Element nach Anspruch 1, d a d u r c h  g e - k e n n z e i c h n e t,  daß die Wasserstoffimplantation selbstjustierend erfolgt.

3. Gunn-Element nach den Ansprüchen 1 und/oder 2, d a - d u r c h  g e k e n n z e i c h n e t,  daß die eingebrachten Isolatorbereiche eine Dicke aufweisen, die der Dicke der epitaktischen Schicht entspricht oder geringer ist als die Dicke der epitaktischen Schicht.

4. Gunn-Element nach Anspruch 3, d a d u r c h  g e - k e n n z e i c h n e t,  daß die Dicke der implantierten Isolatorbereiche ein Drittel bis zwei Drittel der Dicke der epitaktischen Schicht beträgt.

5. Gunn-Element nach mindestens einem der Ansprüche 1 bis 4, d a d u r c h  g e k e n n z e i c h n e t, daß an der größten äußeren Oberfläche des Substrats ein erster Kontakt ganzflächig vorgesehen ist, während an leitenden Bereichen der epitaktisch abgeschiedenen Schicht ein zweiter Kontakt vorgesehen ist.

6. Gunn-Element nach mindestens einem der Ansprüche 1 bis 5, d a d u r c h  g e k e n n z e i c h n e t, daß der zweite Kontakt auch Teile der Isolatorschicht überlagert.

0054647

7. Gunn-Element nach mindestens einem der Ansprüche 1 bis 6, d a d u r c h g e k e n n z e i c h n e t , daß eine Wärmesenke so angebracht ist, daß wahlweise entweder die erste oder die zweite Kontaktschicht mit der 2Bodenplatte fest verbunden ist.

8. Verfahren zur Herstellung eines Gunn-Elementes nach mindestens einem der Ansprüche 1 bis 7, d a d u r c h g e k e n n z e i c h n e t , daß ein Substrat, bestehend aus Galliumarsenid oder Indiumphosphid, das z.B. eine n+-Dotierung aufweist, einseitig mit einer z.B. epi-* taktisch abgeschiedenen Schicht versehen wird, die wiederum mit einer weiteren n+-dotierten epitaktisch abgeschiedenen Schicht bedeckt sein kann, daß auf der bzw. den epitaktisch abgeschiedenen Schichten eine Passivierungsschicht, z.B. bestehend aus $SiO_2$ und/oder $Si_3N_4$, abgeschieden wird, daß mittels fotolithografischer Verfahren die Passivierungsschicht an den Stellen, an denen Kontakte vorgesehen sind, entfernt und abgeschieden wird, daß die verbliebenen Isolatorbereiche dieser Oberfläche frei von Kontaktmaterial bleiben, daß selbstjustierend zu diesen Kontakten eine Wasserstoffimplantation erfolgt, daß danach eine ganzflächige Kontaktabscheidung auf der Oberfläche der epitaktisch abgeschiedenen Schicht erfolgt, daß anschließend mittels fotolithografischer Verfahren das gewünschte Kontaktmuster an der epitaktisch abgeschiedenen Oberfläche erzeugt wird, daß daran anschließend oder vor der selbstjustierenden Wasserstoffimplantation eine ganzflächige Metallisierung der äußeren Substratoberfläche erfolgt, daß anschließend eine integrierte Wärmesenke wahlweise an den Kontaktflecken der epitaktisch abgeschiedenen Schicht oder an der ganzflächigen Substratmetallisierung angebracht wird. *n-dotierten

FIG 1

FIG 2

FIG 3

FIG 4